# FASCICULE DE BREVET EUROPEEN

(11) **EP 4 128 330 B1**
(45) Date de publication et mention de la délivrance du brevet: **27.11.2024**
(21) Numéro de dépôt: 21718933.1
(22) Date de dépôt: 16.03.2021
(51) Int. Cl.: H01L 21/762

(54) **PROCEDE DE FABRICATION D'UNE STRUCTURE EMPILEE**
VERFAHREN ZUM PRODUZIEREN EINER GESTAPELTEN STRUKTUR
METHOD FOR PRODUCING A STACKED STRUCTURE

(30) Priorité: 23.03.2020 FR 2002813
(43) Date de publication de la demande: 08.02.2023
(73) Titulaire: SOITEC, 38190 Bernin (FR)
(72) Inventeur: GHYSELEN, Bruno, 38170 SEYSSINET (FR); DARRAS, François-Xavier, 38140 APPRIEU (FR)
(74) Mandataire: IP Trust
(86) Numéro de dépôt international: PCT/FR2021/050434
(87) Numéro de publication internationale: WO 2021/191527

(56) Documents cités:
- EP-B1- 2 422 365
- FR-A1- 2 940 852
- FR-A1- 3 045 678

## Description

### DOMAINE DE L'INVENTION

La présente invention peut trouver des applications dans les domaines de la microélectronique, des microsystèmes, de l'optoélectronique, de la photonique et des filtres RF. Elle concerne un procédé de fabrication d'une structure empilée comprenant un film superficiel disposé sur un substrat fonctionnalisé.

### ARRIERE PLAN TECHNOLOGIQUE DE L'INVENTION

Dans le domaine de la microélectronique et en particulier des MEMS (« Microelectromechanical systems » selon la terminologie anglo-saxonne), il est généralement utile de transférer une membrane épaisse (par exemple, d'épaisseur supérieure à 5 microns) sur un substrat ayant subi préalablement des étapes de structuration pour intégrer différentes fonctions. Ce substrat fonctionnalisé peut par exemple être muni de cavités et/ou de dispositifs nano ou microélectroniques. La membrane épaisse visée peut notamment être en matériau semi-conducteur, isolant, piézoélectrique ou présenter d'autres propriétés physiques selon l'application visée.

Pour transférer la membrane épaisse, il est connu d'assembler un substrat donneur, dont sera issue la membrane, sur le substrat fonctionnalisé, puis d'amincir mécaniquement et/ou chimiquement le substrat donneur à partir de sa face arrière libre. Un inconvénient de cette approche vient du fait que les traitements mécaniques et chimiques sont contraignants et susceptibles de dégrader la qualité de la membrane au cours du transfert, et/ou du substrat fonctionnalisé. En particulier, lorsque le substrat fonctionnalisé comprend des cavités, la membrane peut présenter des fissures ou des zones exfoliées en vis-à-vis des cavités, ainsi que des non-uniformités d'épaisseur ; lorsque le substrat fonctionnalisé comprend des composants microélectroniques, la membrane montre parfois des non-uniformités d'épaisseur liées aux motifs et topologies des composants sous-jacents, et/ou lesdits composants peuvent subir des dégradations.

Le procédé Smart Cut^{®}, bien connu en soi, est particulièrement adapté au transfert de membranes qualifiées de « minces », c'est-à-dire d'épaisseur typiquement inférieure à 1,5 micron, sur des substrats receveurs, fonctionnalisés ou pas. Cependant, avec des équipements classiques d'implantation d'ions, le transfert de membranes épaisses de plusieurs microns à plusieurs dizaines de microns n'est pas directement accessible.

D'autres procédés sont basés sur un détachement, par application d'une contrainte mécanique ou d'un traitement chimique au niveau d'une interface fragilisée présente dans le substrat donneur. On peut alors qualifier le substrat donneur de « substrat démontable » car il comporte, entre la future membrane et le reste du substrat donneur, ladite interface fragilisée qui sera le lieu du démontage, c'est-à-dire de la séparation.

C'est notamment le cas des procédés décrits dans les documents

EP2422365 B1, FR3045678,
FR2748851, FR2823599, FR2823596 ou WO2019110886. Une limitation de ces approches peut venir du fait que les étapes de détachement, par insertion d'une lame entre les substrats initial et cible assemblés, par application d'importantes contraintes en traction, et/ou par immersion longue dans une solution chimique, sont susceptibles de dégrader la qualité de la membrane. Par ailleurs, le détachement peut parfois se faire au niveau d'interfaces ou de couches autres que celle fragilisée car il reste difficile de localiser précisément la contrainte mécanique et/ou l'attaque chimique au niveau de l'interface fragilisée.

Encore d'autres procédés, basés sur la séparation par laser au niveau d'une interface (« laser lift-off »), requièrent l'utilisation d'un substrat transparent, pour le substrat fonctionnalisé ou pour le substrat donneur, ce qui limite le champ des applications.

### OBJET DE L'INVENTION

La présente invention concerne une solution alternative à celles de l'état de la technique, et vise à remédier à tout ou partie des inconvénients précités. Elle concerne un procédé de fabrication d'une structure empilée comprenant un film superficiel disposé sur un substrat fonctionnalisé.

### BREVE DESCRIPTION DE L'INVENTION

L'invention concerne un procédé de fabrication d'une structure empilée comprenant un substrat receveur et un film superficiel. Le procédé comprend les étapes suivantes :
a) la fourniture d'un substrat support et d'un substrat initial, chacun présentant une face avant et une face arrière,
b) la formation d'un plan fragile enterré dans le substrat support par implantation d'ions légers à travers la face avant dudit substrat,
c) l'assemblage du substrat support et du substrat initial par leurs faces avant respectives,
d) l'amincissement mécanique et/ou chimique du substrat initial par sa face arrière pour former un substrat donneur comprenant une couche donneuse issue du substrat initial et disposée sur le substrat support, et le plan fragile enterré présent dans le substrat support, le substrat donneur présentant une face avant, du côté de la couche donneuse et une face arrière du côté du substrat support,
e) la fourniture d'un substrat receveur présentant une face avant et une face arrière,
f) l'assemblage du substrat donneur et du substrat receveur par leurs faces avant respectives,
g) la séparation le long du plan fragile enterré, de manière à former la structure empilée comprenant le substrat receveur et le film superficiel incluant la couche donneuse et une fine couche transférée issue du substrat support.

Selon d'autres caractéristiques avantageuses et non limitatives de l'invention, prises seules ou selon toute combinaison techniquement réalisable :
- Le procédé comprend une étape, préalablement à l'étape f) d'assemblage, de formation d'au moins une couche fonctionnalisée sur la face avant du substrat donneur et/ou sur la face avant du substrat receveur, la structure empilée comprenant alors le substrat receveur, le film superficiel et la couche fonctionnalisée intercalée entre le substrat receveur et le film superficiel ;
- la couche fonctionnalisée comprend une pluralité de régions micro ou nanostructurées et/ou une pluralité de cavités et/ou une pluralité de composants micro ou nanoélectroniques ;
- les composants sont choisis parmi des transistors, des MEMS, des capteurs, des résonateurs, des imageurs, des actuateurs, des filtres radiofréquences, des diodes et des lasers ;
- les cavités présentent des dimensions latérales comprises entre 1 micron et quelques centaines de microns, et une profondeur de l'ordre de 0,1 micron à quelques dizaines de microns ;
-
- la fine couche transférée est retirée par gravure chimique ;
-
- le film superficiel est formé d'au moins un matériau semi-conducteur choisi parmi le silicium, le germanium, le carbure de silicium, les composés de type III-V, et/ou d'au moins un matériau isolant choisi parmi le saphir, le diamant, et/ou d'au moins un matériau piézoélectrique choisi parmi le tantalate de lithium, le niobate de lithium ;
- le substrat receveur est formé d'au moins un matériau semi-conducteur et/ou isolant et/ métallique, monocristallin, poly-cristallin ou amorphe ;
- le substrat receveur présente une épaisseur comprise entre quelques dizaines de microns et 1000 microns.

### BREVE DESCRIPTION DES FIGURES

D'autres caractéristiques et avantages de l'invention ressortiront de la description détaillée de l'invention qui va suivre en référence aux figures annexées sur lesquelles :
- Les figures 1a, 1b et 1c présentent des exemples de structures empilées obtenues à partir d'un procédé de fabrication conforme à l'invention ;
- Les figures 2a à 2g présentent des étapes d'un procédé de fabrication de la structure empilée, selon un premier mode de réalisation de l'invention ;
- Les figures 3a à 3g présentent des étapes d'un procédé de fabrication de la structure empilée, selon un deuxième mode de réalisation qui ne fait pas partie de l'invention ;
- Les figures 4a et 4b présentent une variante du premier mode de réalisation selon le procédé de fabrication conforme à l'invention ;
- Les figures 5a et 5b présentent une variante du deuxième mode de réalisation

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas respectées sur les figures.

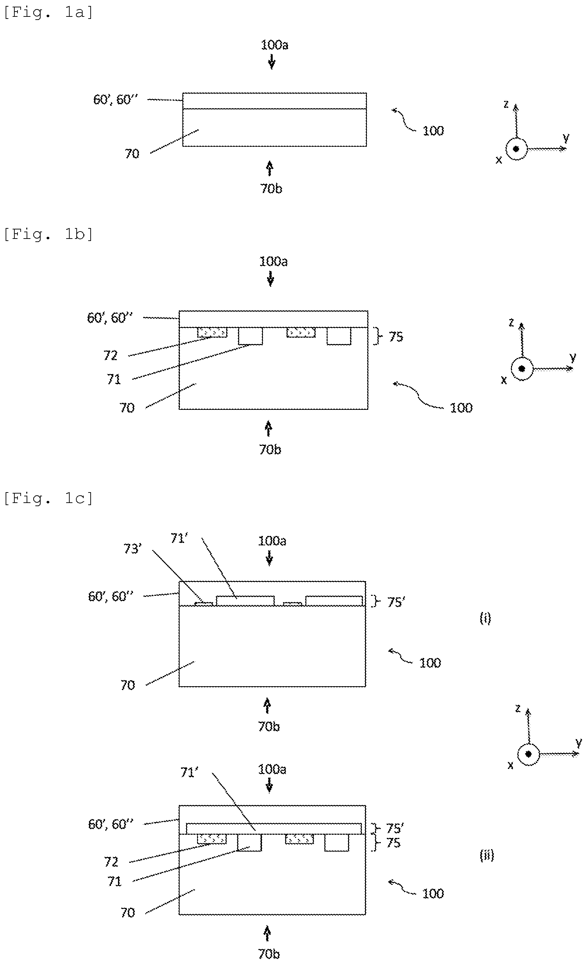

La structure empilée 100 issue du procédé de fabrication selon l'invention comprend un substrat receveur 70 et un film superficiel 60',60", comme illustré sur les figures 1a à 1c.

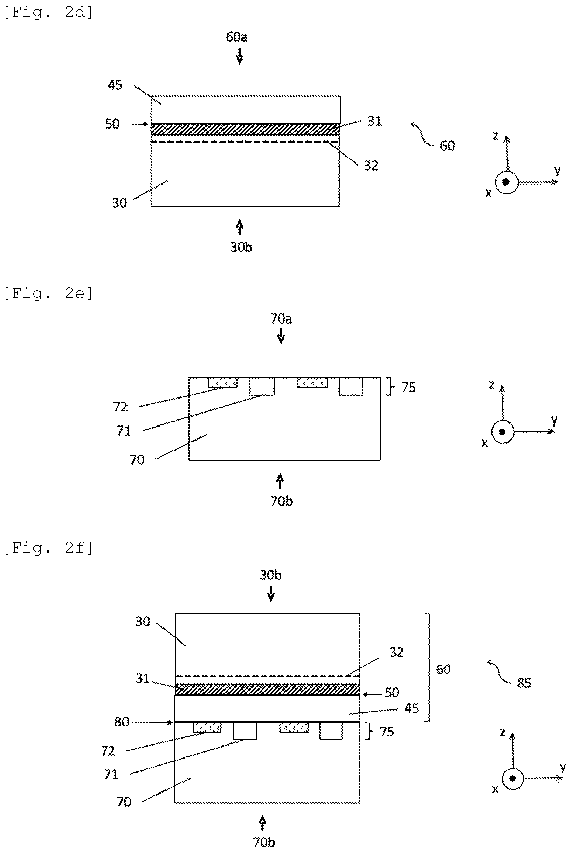

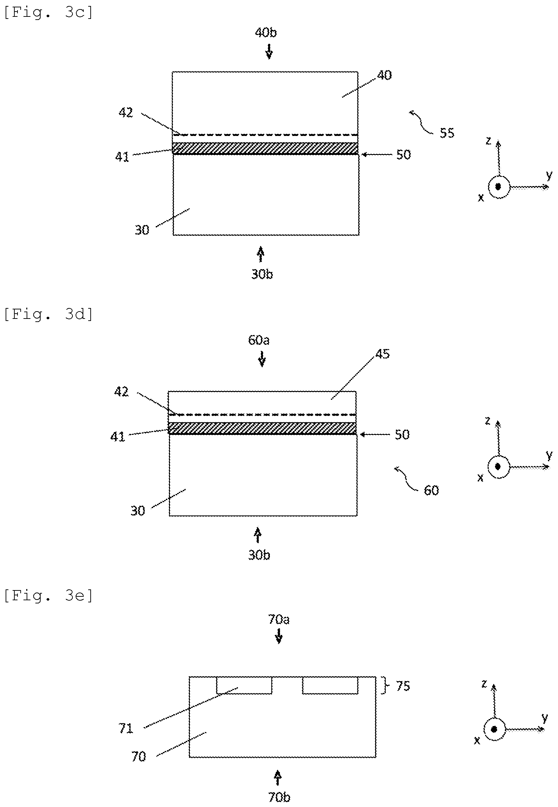

Le substrat receveur 70 présente une face avant 70a et une face arrière 70b (figures 2e et 3e) et a avantageusement la forme d'une plaquette, de diamètre supérieur à 100mm, par exemple 150mm, 200mm, 300mm, voire 450mm. Son épaisseur est typiquement comprise entre quelques dizaines de microns et 1000 microns, par exemple entre 100 microns et 800 microns. Il peut être formé en tout matériau semi-conducteur, isolant ou conducteur, de qualité monocristalline, poly-cristalline ou amorphe, selon l'application visée.

Selon un premier aspect de l'invention illustré sur la figure 1a, le substrat receveur 70 est peu compatible avec les techniques d'amincissement mécanique ou l'application de contraintes mécaniques, soit du fait de la nature du (ou des) matériau(x) dont il est constitué (par exemple, un matériau fragile tel que certains verres), soit du fait de son épaisseur réduite (par exemple, une épaisseur inférieure à 400 microns, à 250 microns, voire encore inférieure à 150 microns).

Selon un deuxième aspect de l'invention, qui peut ou non être combiné avec le premier aspect, le substrat receveur 70 comporte une couche fonctionnalisée 75 (figures 1b, 1c). Par fonctionnalisée, on entend que la couche 75 comprend des régions micro ou nano-structurées, et/ou des cavités 71 remplies ou dépourvues de matériau solide, et/ou une pluralité de composants micro ou nanoélectroniques 72 partiellement ou totalement élaborés. La couche fonctionnalisée 75 peut être formée dans ou sur le substrat receveur 70, au niveau de sa face avant 70a. En général, la couche fonctionnalisée 75 peut donc former tous types de topologies régulièrement ou localement réparties et inclure des matériaux additionnels par rapport à celui (ou ceux) formant le substrat receveur 70. A titre d'exemple, les matériaux additionnels pourront être des oxydes, des nitrures ou des métaux.

La structure empilée 100 comprend également un film superficiel 60',60'' disposé sur le substrat receveur 70. Lorsqu'elle est présente, la couche fonctionnelle 75 est interposée entre le film superficiel 60',60'' et le substrat receveur 70.

Le film 60',60"peut être de diverses natures et présenter différentes propriétés, selon l'application visée pour la structure empilée 100.

Il peut avantageusement comprendre un matériau monocristallin garantissant la stabilité et la reproductibilité de ses propriétés, contrairement par exemple au cas d'un matériau poly-cristallin pour lequel les propriétés mécaniques sont fortement dépendantes des conditions de dépôt (taille et forme des grains, nature des joints de grains, contraintes, etc). Un matériau monocristallin peut également permettre l'élaboration de composants micro ou nanoélectroniques sur ou dans le film superficiel 60',60'' de la structure empilée 100. Lesdits composants pourront être connectés à la couche fonctionnalisée 75 du substrat receveur 70 (quand celle-ci est présente).

Préférentiellement, mais sans que cela ne soit limitatif, le film superficiel 60',60'' peut être formé d'au moins un matériau semi-conducteur choisi parmi le silicium, le germanium, le carbure de silicium, les composés de type III-V, et/ou d'au moins un matériau isolant tel que le saphir, le diamant, et/ou d'au moins un matériau piézoélectrique tel que le tantalate de lithium et le niobate de lithium. Il peut présenter une épaisseur comprise entre 2 microns et 300 microns, avantageusement entre 5 microns et 80 microns.

Généralement, le film superficiel 60',60" peut être formé par une ou plusieurs couches, continues ou discontinues, de différents matériaux.

Selon une première option, le film superficiel 60', 60" de la structure empilée 100 est vierge ou continu, c'est-à-dire sans structurations particulières (figures 1a, 1b). Comme évoqué précédemment, des dépôts, structurations ou autres étapes d'élaboration de dispositifs pourront être réalisés sur sa face libre, face avant 100a, à l'issue de la fabrication de la structure empilée 100.

Selon une deuxième option, le film superficiel 60',60" comporte une couche fonctionnalisée 75', comprenant par exemple des régions micro ou nanostructurées 73' et/ou une ou plusieurs cavité(s) 71' en vis-à-vis de la face avant du substrat receveur 70 (figure 1c). Le film superficiel 60', 60" peut par exemple former une membrane mobile au-dessus de la cavité 71', avec des contacts métalliques 73' prédéfinis, en vue de la fabrication ultérieure d'un dispositif MEMS (figure 1c (i)). Selon un autre exemple, le film superficiel 60',60" peut par exemple procurer un capot d'encapsulation pour les composants 72 de la couche fonctionnalisée 75 du substrat receveur 70, du fait de la présence de la cavité 71' aménagée dans le film superficiel 60',60'', même si les composants 72 forment une topologie importante sur la face avant 70a du substrat receveur 70 (figure 1c (ii)).

Par la suite, on appellera première couche fonctionnalisée 75 et deuxième couche fonctionnalisée 75', les couches fonctionnalisées élaborées respectivement sur le substrat receveur 70 et sur un substrat donneur 60 dont est issue le film superficiel 60',60". On rappelle que toute combinaison du premier aspect de l'invention, du deuxième aspect de l'invention, de la première option et de la deuxième option précitées est envisageable, même si l'ensemble des combinaisons n'est pas nécessairement illustré ou précisé dans la description.

Notons qu'une couche intermédiaire pourra être introduite entre le film superficiel 60',60" et le substrat receveur 70, qu'elle soit disposée du côté du film 60',60" ou du côté du substrat receveur 70, pour favoriser leur assemblage ou pour procurer une fonction d'isolation ou de conduction électrique ou thermique entre le substrat receveur 70 et le film 60', 60".

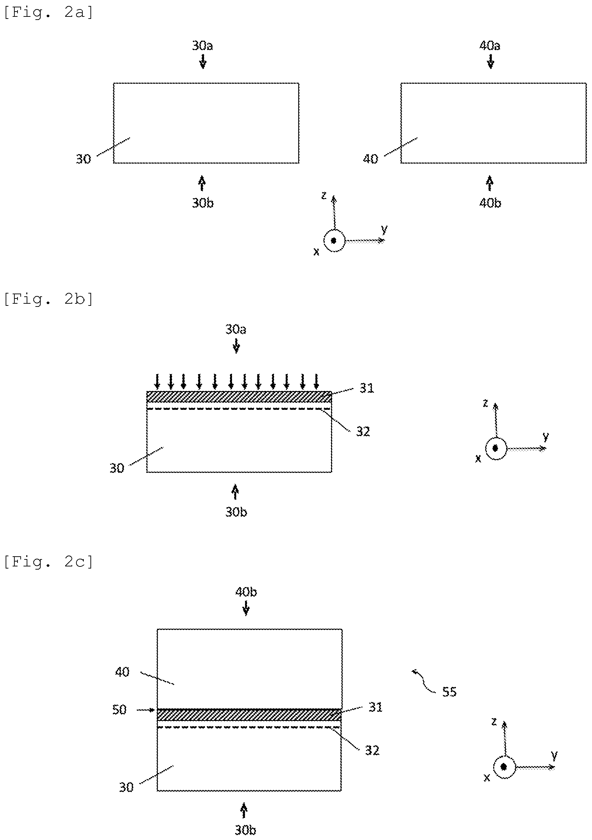

Le procédé de fabrication de la structure empilée 100 précitée va maintenant être décrit en référence aux figures 2a à 2g, 3a à 3g, 4a à 4b et 5a à 5b.

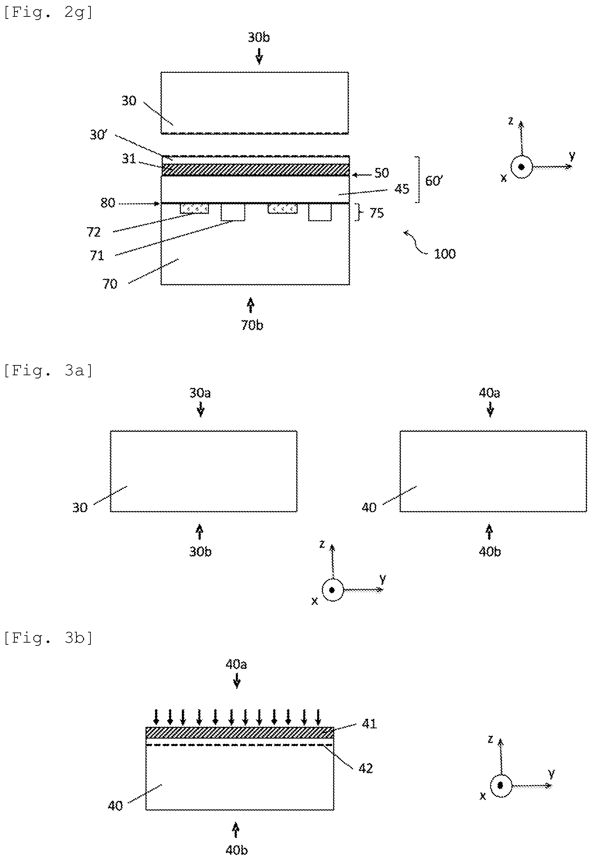

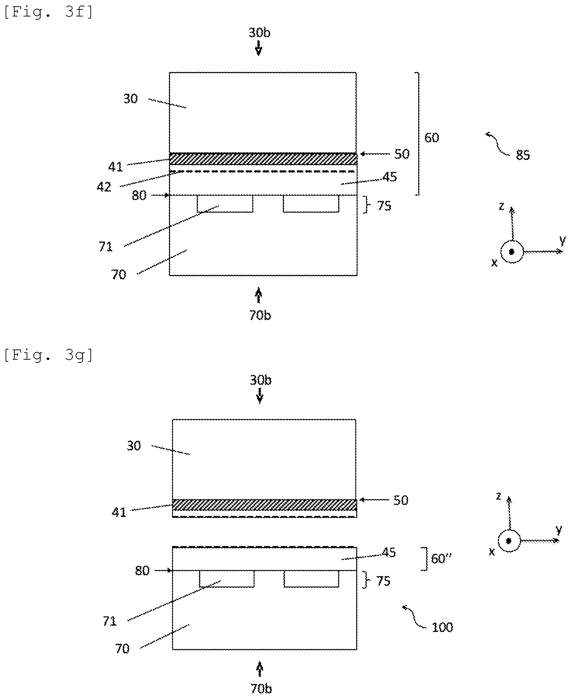

Le procédé de fabrication comprend en premier lieu une étape a) de fourniture d'un substrat support 30 et d'un substrat initial 40, chacun présentant une face avant 30a,40a et une face arrière 30b,40b (figures 2a, 3a). Parmis les deux procédés décrits dans les figures 2 et 3 seul celui de la figure 2 fait partie de l'invention. Ces deux substrats 30,40 ont avantageusement la forme d'une plaquette, de diamètre supérieur à 100mm, par exemple 150mm, 200mm, 300mm, voire 450mm. Leur épaisseur est typiquement comprise entre 200 et 900 microns. Comme cela sera apparent par la suite, le substrat initial 40 est celui dont sera principalement issu le film superficiel 60',60". Ainsi, les matériaux cités précédemment en référence au film superficiel 60',60" s'appliquent, bien-sûr de façon non limitative. La nature et les propriétés du substrat initial 40 sont donc intimement associées à l'application visée pour la structure empilée 100.

Les substrats support 30 et initial 40 pourront être vierges ou comprendre une ou plusieurs couche(s) de nature éventuellement différente de celle des substrats.

L'étape b) suivante du procédé selon l'invention comprend la formation d'un plan fragile enterré 32,42 dans le substrat support 30 ou dans le substrat initial 40, par implantation d'ions légers à travers la face avant de l'un ou l'autre desdits substrats 30,40 (figures 2b, 3b).

Comme cela est bien connu en référence au procédé Smart Cut évoqué en introduction, les ions légers sont avantageusement choisis parmi l'hydrogène, l'hélium ou une combinaison de ces deux espèces. La dose et l'énergie d'implantation sont définies de manière à générer, lors d'une étape g) ultérieure du procédé, une séparation spontanée par application d'un traitement thermique à une température modérée, typiquement inférieure à 700°C, préférentiellement même inférieure à 600°C, à 500°C, à 350°C, voire à 300°C. Il est connu que l'on peut effectivement agir sur la cinétique de coalescence des microfissures présentes dans le plan fragile enterré 32,42, en fonction des espèces implantées, de la dose introduite, du matériau dans lequel est formé ledit plan 32,42, etc.

Selon un premier mode de réalisation, illustré sur la figure 2b et suivantes, le plan fragile enterré 32 est formé dans le substrat support 30. Ce dernier est préférentiellement de nature monocristalline pour favoriser la formation du plan fragile enterré 32 par l'implantation des espèces légères. Une couche de protection 31, par exemple en oxyde de silicium ou en nitrure de silicium, peut éventuellement être disposée sur la face avant 30a du substrat support 30, pour protéger ce dernier lors de l'implantation.

Selon un deuxième mode de réalisation, illustré sur la figure 3b et suivantes, le plan fragile enterré 42 est formé dans le substrat initial 40. Ce dernier est, de préférence, de nature monocristalline pour favoriser la formation du plan fragile enterré 42 par implantation des espèces légères. Optionnellement, une couche de protection 41, par exemple en oxyde de silicium ou en nitrure de silicium, peut être disposée sur la face avant 40a du substrat initial 40, pour protéger ce dernier lors de l'implantation.

De manière générale, pour l'un ou l'autre des modes de réalisation, le substrat support 30 est avantageusement choisi parmi des matériaux à faible coût. On peut citer à titre d'exemple le silicium monocristallin de faible ou moyenne qualité ou poly-cristallin, le verre, etc. Le substrat initial 40 est avantageusement composé d'un ou plusieurs matériaux dont la nature et la qualité (défectivité, cristallinité) sont définies par les spécifications que doit remplir le film superficiel 60',60" de la structure empilée 100 visée. Il pourra notamment comprendre au moins un matériau semi-conducteur et/ou au moins un matériau isolant et/ou au moins un matériau conducteur et/ou au moins un matériau piézoélectrique.

Dans l'un et l'autre des modes de réalisation, le plan fragile enterré 32,42 est situé à moins de 2 microns de la surface libre de la face avant 30a,40a du substrat 30,40. Avantageusement, il est même situé à une profondeur inférieure à 1 micron, voire inférieure à 0,5 micron.

Le procédé de fabrication selon l'invention comprend ensuite une étape c) d'assemblage du substrat support 30 et du substrat initial 40 par leurs faces avant 30a,40a respectives (figures 2c, 3c).

Différents types d'assemblage sont envisageables. On pourra notamment mettre en oeuvre un collage direct à température ambiante, par adhésion moléculaire, ou un collage par thermocompression ou eutectique à basse température (typiquement en dessous de 350°C), avec des surfaces assemblées de nature isolante ou métallique. Une interface d'assemblage 50 est ainsi définie entre les deux substrats 30,40 qui forment à ce stade du procédé une première structure collée 55.

La couche de protection 31,41 peut être conservée ou retirée préalablement à l'étape c) d'assemblage. Lorsqu'elle est conservée, elle peut être utilisée comme une couche intermédiaire susceptible d'améliorer la tenue mécanique de l'interface de collage 50. Lorsqu'elle est retirée, une couche intermédiaire isolante ou conductrice électrique peut être déposée sur l'un ou l'autre des substrats 30,40 à assembler, pour favoriser la qualité du collage (faible défectivité, forte énergie de collage). Alternativement, le substrat initial 40 peut être directement assemblé sur le substrat support 30.

Avantageusement, des séquences de nettoyages et d'activation de surface par plasma sont appliquées aux substrats 30,40 avant leur assemblage, toujours dans le but de garantir une bonne qualité de collage. Des traitements de lissage, par exemple par polissage mécano-chimique, peuvent également leur être appliqués, de manière à planariser au mieux leurs surfaces, et à abaisser la rugosité de surface à hautes et basses fréquences de leurs faces avants respectives 30a,40a.

Optionnellement, un traitement thermique de consolidation de l'interface 50 est opéré, en soumettant la première structure collée 55 à une basse température, typiquement inférieure à 300°C, voire inférieure à 250°C, pendant une durée de l'ordre de quelques heures. Le budget thermique appliqué à la structure collée 55 lors de ce traitement thermique doit impérativement demeurer en-dessous du budget thermique permettant une séparation spontanée au niveau du plan fragile enterré 32,42.

Après l'assemblage, le procédé de fabrication comprend une étape d) d'amincissement mécanique et/ou chimique du substrat initial 40 par sa face arrière 40b pour former un substrat donneur 60 (figures 2d, 3d). Un tel amincissement peut être réalisé par les techniques connues de rodage mécanique (« grinding » selon la terminologie anglo-saxonne), polissage mécano-chimique et/ou gravure chimique. Les substrats initial 40 et support 30 étant vierges ou munis d'empilements simples de couches uniformes et continues, et la première structure collée 55 comportant une interface de collage 50 homogène sur toute sa surface (typiquement sans cavité ou autre structuration), les étapes d'amincissement peuvent être très bien contrôlées et mener à la formation d'une couche donneuse 45 uniforme et parfaitement intègre.

Le substrat donneur 60 comprend une couche donneuse 45 issue du substrat initial 40 et disposée sur le substrat support 30. La couche donneuse 45 pourra présenter une épaisseur comprise entre quelques microns et 300 microns, avantageusement entre 5 microns et 80 microns.

Le substrat donneur 60 présente une face avant 60a, du côté de la couche donneuse 45 et une face arrière 30b du côté du substrat support 30, également face arrière du substrat support 30.

Dans le premier mode de réalisation, le plan fragile enterré 32 est présent dans le substrat support 30 (figure 2d), alors que dans le deuxième mode de réalisation, le plan fragile enterré 42 est dans la couche donneuse 45 (figure 3d). Dans les deux cas, le plan fragile enterré 32,42 se situe à moins de 1,5 micron de l'interface de collage 50, voire à moins de 0,5 micron.

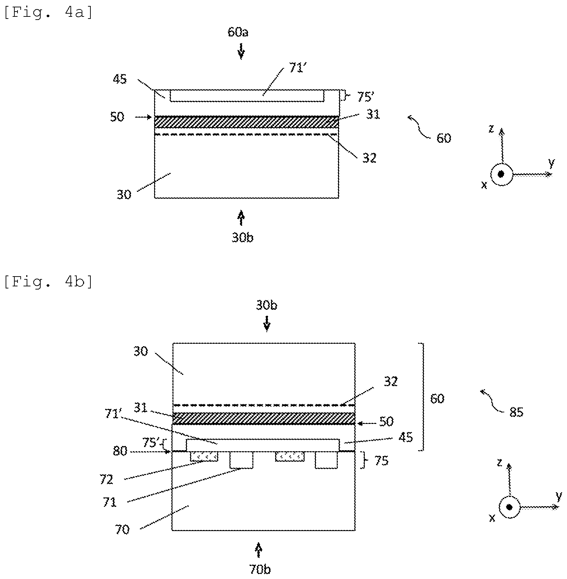

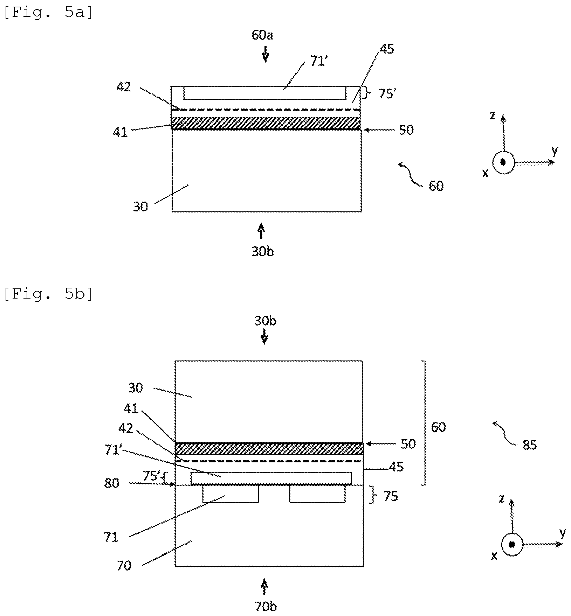

Selon la deuxième option énoncée précédemment, pour laquelle le film superficiel 60',60" de la structure empilée 100 visée par le présent procédé comprend une couche fonctionnelle 75' (deuxième couche fonctionnelle 75'), le procédé de fabrication comprend une étape d') de formation de la deuxième couche fonctionnalisée 75' sur la face avant 60a du substrat donneur 60. Des techniques classiques de microélectronique et/ou de micro ou nano-usinage pourront être mises en oeuvre pour fabriquer des régions micro ou nano-structurées et/ou des cavités 71' (figures 4a, 5a). Compte tenu de la présence du plan fragile enterré 32,42, les séquences de fabrication de la deuxième couche fonctionnelle 75' doivent impliquer uniquement des basses températures, typiquement inférieures à 250°C.

Comme illustré sur les figures 4a (conforme au premier mode de réalisation) et 5a (conforme au deuxième mode de réalisation), le substrat donneur 60 peut par exemple subir une étape de gravure locale, de manière à définir une ou plusieurs cavité(s) 71' du côté de la face avant 60a, dans la couche donneuse 45.

Le procédé de fabrication comprend ensuite une étape e) de fourniture d'un substrat receveur 70 présentant une face avant 70a et une face arrière 70b (figures 2e et 3e). Comme énoncé précédemment, le substrat receveur 70 a avantageusement la forme d'une plaquette, de diamètre supérieur à 100mm, par exemple 150mm, 200mm, 300mm, voire 450mm, son épaisseur est typiquement comprise entre quelques dizaines de microns et 1000 microns ; il peut être formé en tout matériau semi-conducteur, isolant ou conducteur, selon l'application visée. Parce que c'est un matériau disponible, compatible avec tous les procédés microélectroniques et qui présente des propriétés mécaniques et électriques intéressantes, le silicium compose préférentiellement le substrat receveur 70 lorsque ce dernier est pourvu d'une couche fonctionnalisée 75 telle que définie précédemment selon le deuxième aspect de l'invention.

Le substrat receveur 70 peut également être de nature fragile ou très fin comme énoncé dans le premier aspect de l'invention.

Selon le deuxième aspect de l'invention évoqué ci-dessus, le procédé comprend donc une étape e') de formation d'une couche fonctionnalisée 75 sur la face avant 70a du substrat receveur 70. Des techniques classiques de microélectronique et/ou de micro ou nano-usinage pourront être mises en oeuvre pour fabriquer les régions micro ou nano-structurées, les cavités 71, et/ou les composants micro ou nanoélectroniques 72 partiellement ou totalement élaborés de la couche fonctionnelle 75. Ces éléments peuvent correspondre à des composants passifs (résistances, capacités...) ou actifs tels que des transistors ; ils peuvent encore correspondre à des MEMS, des capteurs ou des actuateurs. Ils sont avantageusement basés sur une technologie silicium, mais peuvent aussi être basés sur d'autres filières semiconductrices ou piézoélectriques par exemple.

Une cavité 71 pourra présenter des dimensions latérales, dans le plan (x,y) de la face avant 70a, typiquement comprises entre 1 micron et quelques centaines de microns, par exemple 200 à 500 microns, et une hauteur (ou profondeur), selon l'axe z normal à la face avant 70a, typiquement de l'ordre de 0,1 micron à quelques dizaines de microns.

La (ou les) cavité(s) 71 peut(vent) être vide(s), c'est-à-dire dépourvue(s) de matériau solide, ou remplie(s) d'un matériau solide sacrificiel, qui sera éliminé plus tard, dans le procédé de fabrication de la structure empilée 100 ou lors de la fabrication de dispositifs à partir de ladite structure 100. Alternativement, la cavité 71 peut être remplie d'un matériau utile que l'on préservera par la suite car procurant une fonctionnalité (comme par exemple, une isolation).

On notera qu'il peut être plus avantageux d'avoir, à ce stade, des cavités 71 remplies pour faciliter les étapes ultérieures du procédé de fabrication. Le matériau disposé dans les cavités 71 peut être de l'oxyde de silicium, du nitrure de silicium, du silicium sous forme amorphe ou poly-cristalline, etc. Lorsque le matériau est sacrificiel, il est choisi en fonction de la nature du substrat receveur 70 et éventuellement du film superficiel 60',60". En effet, étant destiné à être éliminé après que la structure empilée 100 soit formée, il doit pouvoir être gravé chimiquement avec une bonne sélectivité vis-à-vis du substrat receveur 70 et du film superficiel 60',60", disposé au-dessus des cavités 71.

Le procédé de fabrication selon l'invention comprend ensuite une étape f) d'assemblage du substrat donneur 60 et du substrat receveur 70 par leurs faces avant 60a,70a respectives (figures 2f, 3f, 4b, 5b).

Comme pour l'étape c) d'assemblage précédente, différents types d'assemblage sont envisageables, comme par exemple un collage direct à température ambiante, par adhésion moléculaire ou un collage par thermocompression ou eutectique à basse température, avec des surfaces assemblées de nature isolante ou métallique. L'assemblage peut être effectué sous atmosphère ambiante, sous vide ou sous une atmosphère contrôlée particulière. Une interface d'assemblage 80 est ainsi définie entre les deux substrats 60,70 qui forment à ce stade du procédé une deuxième structure collée 85.

Même si cela n'est pas représenté sur les figures, il est tout à fait envisageable de former une couche intermédiaire sur la face avant 60a,70a de l'un et/ou l'autre des substrats 60,70 à assembler préalablement à l'étape f). Une couche intermédiaire isolante ou conductrice électrique, selon les besoins de l'application, et susceptible d'améliorer la qualité et la tenue mécanique de l'interface de collage 80 sera privilégiée. A titre d'exemple, une couche intermédiaire en oxyde de silicium, en nitrure de silicium, en poly-silicium ou une couche métallique comme le cuivre peut être utilisée.

Avantageusement, des séquences de nettoyages, d'activation de surface par plasma et/ou des traitements de lissage (tels que par exemple des polissages mécano-chimiques) sont appliqués aux substrats 60,70 avant leur assemblage, toujours dans le but de garantir une bonne qualité de collage.

Optionnellement, un traitement thermique de consolidation de l'interface 80 est opéré, en soumettant la deuxième structure collée 85 à une basse température, typiquement inférieure à 300°C. Le budget thermique appliqué à la structure collée 85 lors de ce traitement thermique demeure ici en-dessous du budget thermique permettant une séparation spontanée au niveau du plan fragile enterré 32,42.

Le procédé de fabrication selon l'invention comprend enfin une étape g) de séparation, le long du plan fragile enterré 32,42, de manière à former la structure empilée 100 incluant le substrat receveur 70, le film superficiel 60',60" comprenant tout ou partie de la couche donneuse 45, et lorsque l'une et/ou l'autre d'entre elles est(sont) présente(s), la première 75 et la deuxième 75' couches fonctionnalisées (figures 2g, 3g, 1a à 1c).

La séparation le long du plan fragile enterré 32,42 est obtenue par un traitement thermique qui va provoquer une fracture dans la zone de microfissures sous pression gazeuses générée par les espèces implantées.

Dans le cas d'un plan fragile enterré 32,42 formé dans du silicium, le traitement thermique est effectué à une température typiquement comprise entre 200° et 600°C, pendant quelques minutes à quelques heures, de manière à provoquer une propagation spontanée de la fracture le long du plan fragile 32,42.

Bien sûr, dans le cas où la première 75 et/ou la deuxième 75' couche fonctionnalisée intègre des matériaux sensibles aux moyennes et hautes températures, la température du traitement thermique de séparation sera choisie la plus basse possible, par exemple entre 200°C et 325°C.

Éventuellement, le budget thermique peut être complété par l'application d'une contrainte mécanique d'intensité raisonnable. Dans ce cas, pour éviter que la séparation ne s'opère à d'autres interfaces ou dans d'autres couches que le plan fragile enterré 32,42, on prendra soin d'appliquer un budget thermique de fragilisation important audit plan fragile 32,42, de manière à ne nécessiter qu'une contrainte mécanique faible, juste suffisante pour initier la propagation spontanée de la fracture.

Selon le premier mode de réalisation illustré sur la figure 2g, le film superficiel 60' comporte la couche donneuse 45 épaisse, une couche intermédiaire 31 (couche de protection ou couche de collage) si elle est présente, et une fine couche transférée 30' du substrat support 30. En effet, le plan fragile enterré 32 étant situé dans le substrat support 30, la séparation donne lieu à une couche transférée 30' solidaire de la structure empilée 100 d'une part, et à un reste de substrat support 30. La couche transférée 30' et éventuellement la couche intermédiaire 31 peuvent être aisément retirées par gravure chimique, sèche ou humide. Compte tenu de leurs faibles épaisseurs, une telle gravure chimique est très bien contrôlée et rapide, et elle ne constitue pas une étape agressive et susceptible de dégrader la structure empilée 100. A l'issue de cette gravure, on obtient une structure empilée 100 comportant un film superficiel 60' constitué de la couche donneuse 45 épaisse, typiquement entre quelques microns et 100 microns, ou préférentiellement entre 5 microns et 50 microns, de très bonne qualité : en effet, l'intégrité et l'uniformité d'épaisseur de la couche donneuse 45 sont assurées lors de l'étape d) d'amincissement de la première structure collée 55 ; cette étape est très bien maîtrisée car opérée sur des substrats vierges avec éventuellement des empilements simples de couches uniformes et continues. L'étape g) de séparation appliquée à la deuxième structure collée 85, pouvant comporter la (ou les) couche(s) fonctionnalisée(s) 75,75' est beaucoup moins contraignante que les étapes d'amincissement mécanique et chimique longues et agressives (retrait de plusieurs dizaines de microns de matière) ou les étapes de séparation mécanique qui sont proposées dans l'état de la technique pour transférer un film superficiel 60' épais sur un substrat receveur 70.

Dans le deuxième mode de réalisation illustré sur la figure 3g, le film superficiel 60" est constitué d'une partie transférée de la couche donneuse 45. En effet, le plan fragile enterré 42 étant situé dans le substrat initial 40, et plus particulièrement dans la couche donneuse 45, la séparation donne lieu à une partie transférée 60" solidaire de la structure empilée 100 d'une part, et à un reste du substrat donneur 60.

Des étapes de polissage mécano-chimique, nettoyages et/ou gravure chimique, retirant quelques centaines de nanomètres au film superficiel 60" du côté de la face avant 100a de la structure empilée 100, permettent aisément, si cela est nécessaire au vu de l'application, de restaurer un bon état de surface (faible rugosité, faible défectivité) au film superficiel 60". Il n'est pas requis de retirer beaucoup de matière car la zone défectueuse résiduelle à l'issue de la séparation du plan fragile enterré 42 est de faible épaisseur, comme cela est connu en référence au procédé Smart Cut. Dans ce deuxième mode de réalisation, on obtient également une structure empilée 100 comportant un film superficiel 60" épais, typiquement entre quelques microns et 100 microns, ou préférentiellement entre 5 microns et 50 microns, de très bonne qualité car l'intégrité et l'uniformité d'épaisseur de la couche donneuse 45 sont assurées lors de l'étape d) d'amincissement de la première structure collée 55.

Le procédé de fabrication selon l'invention permet ainsi de transférer un film superficiel 60',60" épais, de grande qualité cristalline (lorsque la couche donneuse 45 est monocristalline), présentant une parfaite intégrité et une excellente uniformité d'épaisseur, même lorsqu'il est reporté sur une couche fonctionnalisée 75 comportant des composants 72, des cavités 71 et/ou autres couches structurées.

Lorsque la première couche fonctionnelle 75 comprend des cavités 71, il est possible d'élaborer des dispositifs, basés sur des membranes, parties du film superficiel 60',60" , mobiles au-dessus des cavités 71, à partir de la structure empilée 100 obtenue. Il est alors nécessaire de graver sélectivement le matériau sacrificiel remplissant les cavités 71, si lesdites cavités 71 sont effectivement remplies à ce stade du procédé.

Notons que le reste du substrat support 30 ou le reste du substrat donneur 60 peut être traité en vue de sa réutilisation pour un nouveau cycle de fabrication.

**Selon un premier exemple,** les substrats mis en oeuvre sont des plaquettes de 300mm de diamètre.

Le substrat initial 40 est un substrat massif en silicium monocristallin comprenant une couche d'oxyde de silicium SiO2 thermique de 0,3 micron, au moins sur sa face avant 40a.

Le substrat support 30 est un substrat massif en silicium monocristallin de grade inférieur (faible coût), comprenant une couche d'oxyde de silicium SiO2 thermique de 0,3 micron, au moins sur sa face avant 30a. Les substrats initial 40 et support 30 présentent des épaisseurs standard (de l'ordre de 700-800 microns) .

Le substrat initial 40 est implanté, au niveau de sa face avant 40a, avec des ions hydrogène H+ avec une dose classique de l'ordre de 6^{E}16/cm2 et à une énergie comprise entre 60 et 120keV, de manière à former le plan fragile enterré 42.

L'assemblage des faces avant 40a,30a du substrat initial 40 et du substrat support 30 met en oeuvre un collage direct SiO2/SiO2, à température ambiante. Un recuit de consolidation à basse température entre 200°C et 250°C, pendant 1h à 2h, est ensuite appliqué à la structure collée 55.

La structure collée 55 est ensuite amincie, au niveau de la face arrière 40b du substrat initial 40, par rectification mécanique (grinding) et détourage mécanique. Ces étapes de rodage mécanique sont suivies d'un polissage mécano-chimique et de séquences classiques de nettoyages (de type SC1, SC2, etc), de manière à former le substrat donneur 60. La couche donneuse 45 présente une épaisseur de 15 microns, et une qualité (défectivité, rugosité) de surface compatible avec un assemblage ultérieur (typiquement, une rugosité inférieure à 0,5nm RMS) sur le substrat receveur 70.

Le substrat receveur 70 est un substrat massif en silicium monocristallin, d'épaisseur inférieure à 400 microns, poli en face arrière et comprenant une couche d'oxyde de silicium SiO2 thermique de 0,3 micron, au moins sur sa face avant 70a.

Une couche fonctionnalisée 75 est formée sur le substrat receveur 70, par exemple par lithographie et gravure locale : elle comprend une pluralité de cavités 71 isolées les unes des autres, de profondeur 5 microns et de dimensions latérales 350 microns. Les cavités 71 pourront présenter une forme ronde, carrée ou autre forme polygonale, dans le plan de la face avant 70a.

L'assemblage du substrat donneur 60 et du substrat receveur 70 est effectué par collage direct à température ambiante, sous atmosphère ambiante ou sous vide.

Un traitement thermique à 400°C est ensuite appliqué de manière à générer la séparation le long du plan fragile enterré 42, donnant lieu, d'une part à la structure empilée 100 avec son film superficiel 60" et d'autre part au reste du substrat donneur 60.

Pour restaurer la qualité et la rugosité de surface du film superficiel 60", un traitement thermique comprenant une oxydation sacrificielle ou de lissage peut être appliqué. Optionnellement, un polissage mécano-chimique avec un faible enlèvement (typiquement, moins de 0,5 micron) et/ou une gravure chimique peuvent être appliqués.

Une telle structure empilée 100 peut par exemple être utilisée pour la fabrication d'un capteur de pression.

**Dans un deuxième exemple,** les substrats mis en oeuvre sont des plaquettes de 200mm ou 300mm de diamètre.

Le substrat initial 40 est un substrat massif en silicium monocristallin de grade inférieur (faible coût).

Le substrat support 30 est un substrat massif en silicium monocristallin de grade inférieur, comprenant une couche d'oxyde de silicium SiO2 thermique de 0,4 micron, au moins sur sa face avant 30a. Les substrats initial 40 et support 30 présentent des épaisseurs standard (de l'ordre de 700-800 microns).

Le substrat support 30 est implanté, au niveau de sa face avant 30a, avec des ions hydrogène H+ avec une dose classique de l'ordre de 6^{E}16/cm2 et à une énergie comprise entre 60 et 120keV, de manière à former le plan fragile enterré 32.

L'assemblage des faces avant 40a,30a du substrat initial 40 et du substrat support 30 met en oeuvre un collage direct Si/SiO2, à température ambiante. Un recuit de consolidation à basse température entre 200°C et 250°C, pendant 1h à 2h, est ensuite appliqué à la structure collée 55.

La structure collée 55 est ensuite amincie, au niveau de la face arrière 40b du substrat initial 40, par rectification mécanique (grinding) incluant un détourage mécanique, suivie d'un polissage mécano-chimique et de séquences classiques de nettoyages (de type SC1, SC2, etc), de manière à former le substrat donneur 60. La couche donneuse 45 présente une épaisseur de 30 microns, et une qualité (défectivité, rugosité) de surface compatible avec un assemblage ultérieur (typiquement, une rugosité inférieure à 0,5nm RMS) sur le substrat receveur 70.

Le substrat receveur 70 est formé de silicium monocristallin et comprend des composants MEMS de type accéléromètres ou gyroscopes, lesquels forment la première couche fonctionnalisée 75.

Une deuxième couche fonctionnalisée 75' est formée sur la couche donneuse 45, par exemple par lithographie et gravure locale : elle comprend une pluralité de cavités 71', de profondeur 3 microns et de dimensions latérales 1,5mm x 1,5mm.

L'assemblage du substrat donneur 60 et du substrat receveur 70 est effectué par collage direct à température ambiante, sous vide.

Un traitement thermique entre 350°C et 450°C peut ensuite être appliqué de manière à générer la séparation le long du plan fragile enterré 32, donnant lieu, d'une part à la structure empilée 100 avec son film superficiel 60' et d'autre part au reste du substrat support 30.

Pour restaurer la qualité et la rugosité de surface du film superficiel 60', un faible enlèvement (typiquement, moins de 0,5 micron) par gravure chimique peut être réalisé.

Une telle structure empilée 100 peut par exemple être utilisée pour la fabrication l'assemblage et l'encapsulation à l'échelle du substrat (« wafer level packaging ») de capteurs inertiels.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure empilée (100) comprenant un substrat receveur (70) et un film superficiel (60'), le procédé comprenant les étapes suivantes :
a) la fourniture d'un substrat support (30) et d'un substrat initial (40), chacun présentant une face avant (30a,40a) et une face arrière (30b,40b),
b) la formation d'un plan fragile enterré (32) dans le substrat support (30), par implantation d'ions légers à travers la face avant (30a) dudit substrat,
c) l'assemblage du substrat support (30) et du substrat initial (40) par leurs faces avant (30a,40a) respectives,
d) l'amincissement mécanique et/ou chimique du substrat initial (40) par sa face arrière (40b) pour former un substrat donneur (60) comprenant une couche donneuse (45) issue du substrat initial (40) et disposée sur le substrat support (30), et le plan fragile enterré (32) présent dans le substrat support (30), le substrat donneur (60) présentant une face avant (60a), du côté de la couche donneuse (45) et une face arrière (30b) du côté du substrat support (30),
e) la fourniture d'un substrat receveur (70) présentant une face avant (70a) et une face arrière (70b),
f) l'assemblage du substrat donneur (60) et du substrat receveur (70) par leurs faces avant (60a,70a) respectives,
g) la séparation le long du plan fragile enterré (32,42), de manière à former la structure empilée (100) comprenant le substrat receveur (70) et le film superficiel (60') incluant la couche donneuse (45) et une fine couche transférée (30') issue du substrat support (30).

2. Procédé de fabrication selon la revendication précédente, comprenant une étape, préalablement à l'étape f) d'assemblage, de formation d'au moins une couche fonctionnalisée (75,75') sur la face avant (60a) du substrat donneur (60) et/ou sur la face avant (70a) du substrat receveur (70), la structure empilée (100) comprenant alors le substrat receveur (70), le film superficiel (60') et la couche fonctionnalisée (75,75') intercalée entre le substrat receveur (70) et le film superficiel (60').

3. Procédé de fabrication selon la revendication précédente, dans lequel la couche fonctionnalisée (75,75') comprend une pluralité de régions micro ou nanostructurées (73') et/ou une pluralité de cavités (71,71') et/ou une pluralité de composants micro ou nanoélectroniques (72).

4. Procédé de fabrication selon la revendication précédente, dans lequel les composants (72) sont choisis parmi des transistors, des MEMS, des capteurs, des résonateurs, des imageurs, des actuateurs, des filtres radiofréquences, des diodes et des lasers.

5. Procédé de fabrication selon l'une des deux revendications précédentes, dans lequel les cavités (71,71') présentent des dimensions latérales comprises entre 1 micron et quelques centaines de microns, et une profondeur de l'ordre de 0,1 micron à quelques dizaines de microns.

6. Procédé de fabrication selon l'une des revendications précédentes, dans lequel la fine couche transférée (30') est retirée par gravure chimique.

7. Procédé de fabrication selon l'une des revendications précédentes, dans lequel le film superficiel (60') est formé d'au moins un matériau semi-conducteur choisi parmi le silicium, le germanium, le carbure de silicium, les composés de type III-V, et/ou d'au moins un matériau isolant choisi parmi le saphir, le diamant, et/ou d'au moins un matériau piézoélectrique choisi parmi le tantalate de lithium, le niobate de lithium.

8. Procédé de fabrication selon l'une des revendications précédentes, dans lequel le substrat receveur (70) est formé d'au moins un matériau semi-conducteur et/ou isolant et/ métallique, monocristallin, poly-cristallin ou amorphe.

9. Procédé de fabrication selon l'une des revendications précédentes, dans lequel le substrat receveur (70) présente une épaisseur comprise entre quelques dizaines de microns et 1000 microns.

## Patentansprüche

1. Verfahren zum Herstellen einer gestapelten Struktur (100), umfassend ein Aufnahmesubstrat (70) und eine Oberflächenfolie (60'), wobei das Verfahren die folgenden Schritte umfasst:
a) Bereitstellen eines Trägersubstrats (30) und eines Ausgangssubstrats (40), die jeweils eine Vorderseite (30a, 40a) und eine Rückseite (30b, 40b) aufweisen,
b) Ausbilden einer eingebetteten brüchigen Ebene (32) in dem Trägersubstrat (30) über Implantation leichter Ionen über die Vorderseite (30a) des Substrats,
c) Zusammenfügen des Trägersubstrats (30) und des Ausgangssubstrats (40) über ihre jeweiligen Vorderseiten (30a, 40a),
d) mechanisches und/oder chemisches Verdünnen des Ausgangssubstrats (40) über seine Rückseite (40b) zum Ausbilden eines Donorsubstrats (60), umfassend eine Donorschicht (45), die von dem Ausgangssubstrat (40) stammt und auf dem Trägersubstrat (30) angeordnet ist, und die eingebettete brüchige Ebene (32), die in dem Trägersubstrat (30) vorhanden ist, wobei das Donorsubstrat (60) eine Vorderseite (60a) auf der Seite der Donorschicht (45) und eine Rückseite (30b) auf der Seite des Trägersubstrats (30) aufweist,
e) Bereitstellen eines Aufnahmesubstrats (70), das eine Vorderseite (70a) und eine Rückseite (70b) aufweist,
f) Zusammenfügen des Donorsubstrats (60) und des Aufnahmesubstrats (70) über ihre jeweiligen Vorderflächen (60a, 70a),
g) Trennen entlang der eingebetteten brüchigen Ebene (32, 42), um die gestapelte Struktur (100) auszubilden, umfassend das Aufnahmesubstrat (70) und die Oberflächenfolie (60'), einschließlich der Donorschicht (45) und einer dünnen übertragenen Schicht (30'), die von dem Trägersubstrat (30) stammt.

2. Herstellungsverfahren nach dem vorstehenden Anspruch, umfassend einen Schritt vor dem Zusammenfügeschritt f) des Ausbildens mindestens einer funktionalisierten Schicht (75, 75') auf der Vorderseite (60a) des Donorsubstrats (60) und/oder auf der Vorderseite (70a) des Aufnahmesubstrats (70), wobei die gestapelte Struktur (100) dann das Aufnahmesubstrat (70), die Oberflächenfolie (60') und die zwischen dem Aufnahmesubstrat (70) und der Oberflächenfolie (60') eingeschobene funktionalisierte Schicht (75, 75') umfasst.

3. Herstellungsverfahren nach dem vorstehenden Anspruch, wobei die funktionalisierte Schicht (75, 75') eine Vielzahl von mikro- oder nanostrukturierten Bereichen (73') und/oder eine Vielzahl von Hohlräumen (71, 71') und/oder eine Vielzahl von mikro- oder nanoelektronischen Komponenten (72) umfasst.

4. Herstellungsverfahren nach dem vorstehenden Anspruch, wobei die Komponenten (72) aus Transistoren, MEMS, Sensoren, Resonatoren, Bildgebern, Aktuatoren, Hochfrequenzfiltern, Dioden und Lasern ausgewählt sind.

5. Herstellungsverfahren nach einem der zwei vorstehenden Ansprüche, wobei die Hohlräume (71, 71') laterale Abmessungen zwischen 1 Mikrometer und einigen hundert Mikrometern und eine Tiefe in der Größenordnung von 0,1 Mikrometer bis einigen zehn Mikrometern aufweisen.

6. Herstellungsverfahren nach einem der vorstehenden Ansprüche, wobei die dünne übertragene Schicht (30') über chemisches Ätzen entfernt wird.

7. Herstellungsverfahren nach einem der vorstehenden Ansprüche, wobei die Oberflächenfolie (60') aus mindestens einem Halbleitermaterial, das aus Silizium, Germanium, Siliziumkarbid, Komponenten des Typ III-V ausgewählt ist, und/oder mindestens einem Isoliermaterial, das aus Saphir, Diamant ausgewählt ist, und/oder mindestens einem piezoelektrischen Material, das aus Lithiumtantalat, Lithiumniobat ausgewählt ist, ausgebildet wird.

8. Herstellungsverfahren nach einem der vorstehenden Ansprüche, wobei das Aufnahmesubstrat (70) aus mindestens einem halbleitenden und/oder isolierenden und/oder metallischen, monokristallinen, polykristallinen oder amorphen Material ausgebildet wird.

9. Herstellungsverfahren nach einem der vorstehenden Ansprüche, wobei das Aufnahmesubstrat (70) eine Dicke zwischen einigen zehn Mikrometern und 1000 Mikrometern aufweist.

## Claims

1. Method for manufacturing a stacked structure (100) comprising a receiving substrate (70) and a surface film (60'), the method comprising the following steps:
a) providing a support substrate (30) and an initial substrate (40), each having a front face (30a, 40a) and a rear face (30b, 40b),
b) forming a buried brittle plane (32) in the support substrate (30), by implanting lightweight ions through the front face (30a) of said substrate,
c) joining the support substrate (30) and the initial substrate (40) by their respective front faces (30a, 40a),
d) mechanically and/or chemically thinning the initial substrate (40) from the rear face (40b) thereof to form a donor substrate (60) comprising a donor layer (45) that originates from the initial substrate (40) and is arranged on the support substrate (30), and the buried brittle plane (32) present in the support substrate (30), the donor substrate (60) having a front face (60a) on the side of the donor layer (45) and a rear face (30b) on the side of the support substrate (30),
e) providing a receiving substrate (70) having a front face (70a) and a rear face (70b),
f) joining the donor substrate (60) and the receiving substrate (70) by their respective front faces (60a, 70a),
g) separating along the buried brittle plane (32, 42), so as to form the stacked structure (100) comprising the receiving substrate (70) and the surface film (60') including the donor layer (45) and a thin transferred layer (30') that originates from the support substrate (30).

2. Manufacturing method according to the preceding claim, comprising a step, prior to the joining step f), of forming at least one functionalized layer (75, 75') on the front face (60a) of the donor substrate (60) and/or on the front face (70a) of the receiving substrate (70), the stacked structure (100) then comprising the receiving substrate (70), the surface film (60') and the functionalized layer (75, 75') interposed between the receiving substrate (70) and the surface film (60').

3. Manufacturing method according to the preceding claim, wherein the functionalized layer (75, 75') comprises a plurality of micro- or nano-structured regions (73') and/or a plurality of cavities (71, 71') and/or a plurality of micro- or nano-electronic components (72).

4. Manufacturing method according to the preceding claim, wherein the components (72) are selected from transistors, MEMS, sensors, resonators, imagers, actuators, radio frequency filters, diodes and lasers.

5. Manufacturing method according to either of the two preceding claims, wherein the cavities (71, 71') have lateral dimensions of between 1 micron and a few hundred microns, and a depth of around 0.1 micron to a few tens of microns.

6. Manufacturing method according to any of the preceding claims, wherein the thin transferred layer (30') is removed by means of chemical etching.

7. Manufacturing method according to any of the preceding claims, wherein the surface film (60') is formed from at least one semiconductor material chosen from silicon, germanium, silicon carbide and III-V-type compounds, and/or at least one insulating material chosen from sapphire and diamond, and/or at least one piezoelectric material chosen from lithium tantalate and lithium niobate.

8. Manufacturing method according to any of the preceding claims, wherein the receiving substrate (70) is formed from at least one monocrystalline, polycrystalline or amorphous semiconductor and/or insulating and/ metal material.

9. Manufacturing method according to any of the preceding claims, wherein the receiving substrate (70) has a thickness of between a few tens of microns and 1000 microns.
